# EUROPEAN PATENT SPECIFICATION

(11) **EP 4 327 373 B1**
(45) Date of publication and mention of the grant of the patent: **12.11.2025**
(21) Application number: 22719652.4
(22) Date of filing: 16.03.2022
(51) Int. Cl.: H01L 23/14, H01L 23/49, G11C 11/44, H10N 60/01, H10N 69/00

(54) **MULTILAYER SUPERCONDUCTING STRUCTURES FOR CRYOGENIC ELECTRONICS**
MEHRSCHICHTIGE SUPRALEITENDE STRUKTUREN FÜR KRYOGENE ELEKTRONIK
STRUCTURES SUPRACONDUCTRICES MULTICOUCHES POUR L'ÉLECTRONIQUE CRYOGÉNIQUE

(30) Priority: 23.04.2021 US 202117239458
(43) Date of publication of application: 28.02.2024
(73) Proprietor: Microsoft Technology Licensing, LLC, Redmond, WA 98052-6399 (US)
(72) Inventor: LEE, Cliff, Redmond, Washington 98052-6399 (US); ROUSE, Richard P., Redmond, Washington 98052-6399 (US); TUCKERMAN, David B., Redmond, Washington 98052-6399 (US); GRIGGIO, Flavio, Redmond, Washington 98052-6399 (US); CANTALOUBE, Christopher, Redmond, Washington 98052-6399 (US)
(74) Representative: Page White Farrer
(86) International application number: PCT/US2022/020463
(87) International publication number: WO 2022/225628

(56) References cited:
- JP-A- 2016 207 506
- JP-A- H02 286 768
- JP-A- H05 208 899
- US-A1- 2014 187 428

## Description

### BACKGROUND

The present disclosure relates generally to interconnect structures for electronic components, and more specifically to multilayer superconducting interconnect structures for use in electronic systems operating at deep cryogenic temperatures.

A typical electronic system is designed to operate at ambient or room temperatures, and includes electronic components integrated through circuit boards fabricated as a multilayer stack structure from dielectric layers and conductive layers. Electronic chips are mounted on either side of this multilayer stack structure and electrically interconnected through the conductive layers and conductive vias interconnecting these conductive layers. Cryogenic electronic systems operating at deep cryogenic temperatures (e.g., less than 10 Kelvin (10 K)) also require multilayer interconnect structures to electrically interconnect active and passive components forming the system. Deep cryogenic temperatures, however, present unique challenges to the configuration and fabrication of these multilayer interconnect structures and components attached to these structures.

In cryogenic electronic systems, the heat generated by the interconnect structures and components attached to these structures must be minimized. This is due to the sensitivity of active and passive components, such as superconducting and quantum devices, to temperature and the limitations and costs of providing cooling capacity to the system at deep cryogenic temperatures. The materials utilized in forming the interconnect structures for cryogenic systems are accordingly of critical importance. Superconducting materials are typically utilized for forming the conductive layers to reduce the joule heating generated in the conductive layers. Ideally, the interconnect structure also provides heat dissipation for components attached to this structure, but while this may be true for interconnect structures at room temperatures at deep cryogenic temperatures most materials experience a reduction in thermal conductivity as a function of temperature. Differences in the coefficient of thermal expansion (CTE) of different materials utilized in the interconnect structure may further limit suitable materials since such differences can result in mechanical stresses in the structure as temperature changes. All these limitations and requirements of interconnect structures in cryogenic systems make the design and fabrication of these structures difficult, and improved interconnect structures are accordingly needed.

JP 2016 207506 A discloses a superconducting wire rod which comprises a body part comprising a superconductive material layer; and a reinforcement part that mechanically reinforces the body part. The reinforcement part consists of a non-solid copper alloy comprising a first material comprising copper or a copper-containing alloy, and a second material different from the first material.

US 2014/0187428 A1 discloses an insulated high-temperature wire superconductor including a wire of a non-insulated high temperature wire superconductor, the width of which is at least 10 times its thickness and in which a high-temperature superconductor is introduced into a matrix or is applied to a substrate.

JP H05-208899 A discloses a superconducting thin film and a method for its manufacture.

JP H02-286768 A discloses an insulating adhesive composition for a circuit board, which can be filled with a specific inorganic filler at a high level, has a high thermal conductivity, and has a high adhesion to a metal substrate.

### SUMMARY

In one aspect, the present invention provides a cryogenic multilayer interconnect structure according to claim 1. In another aspect, the present invention provides a method of forming a cryogenic multilayer interconnect structure according to claim 7. Certain more specific aspects of the invention are set out in the dependent claims.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
Figure 1 is a cross-sectional view of a cryogenic multilayer interconnect structure including a molybdenum substrate according to a reference example.
Figure 2A is a cross-sectional views of a cryogenic multilayer interconnect structure including a multilayered molybdenum substrate according to an embodiment of the invention.
Figure 2 B is a cross-sectional view of a cryogenic multilayer interconnect structure including a multilayered molybdenum substrate according to a reference example.
Figure 3 is a graph illustrating the relatively high thermal conductivity of the conductive layers of the multilayer interconnect structure of Figure 2.
Figure 4 is a cross-sectional view of a cryogenic multilayer interconnect structure according to an embodiment.
Figure 5 is a cross-sectional view of a cryogenic multilayer interconnect structure including several components attached to the interconnect structure according to a further embodiment.
Figure 6 is a cross-sectional view of a cryogenic multilayer interconnect structure including dual interconnect levels according to yet a further embodiment.
Figure 7 is a cross-sectional view of a cryogenic multilayer interconnect structure including transmission line structures for propagation of radio frequency signals according to a reference example.
Figures 8A-8I illustrate a process of fabricating a cryogenic multilayer interconnect structure according to an embodiment of the present invention.
Figure 9 is a simplified functional block diagram of a cryogenic electronic system including one or more multilayer interconnect structures.

### DETAILED DESCRIPTION

In the following description, for purposes of explanation, numerous examples and specific details are set forth in order to provide a thorough understanding of the present disclosure. It will be evident, however, to one skilled in the art that the present disclosure as expressed in the claims may include some or all of the features in these examples, alone or in combination with other features described below, and may further include modifications and equivalents of the features and concepts described herein.

Further, spatially relative terms, such as "beneath," "below," "lower," "above," "upper", "on," "over" and the like, may be used herein for ease of description to describe one element or feature in relation to another element or feature as illustrated in the figures. The spatially relative terms are intended to encompass different orientations of the described structures in use or operation in addition to the orientation depicted in the figures. The structures may be otherwise oriented, such as through a 90-degree rotation or at other orientations, and the spatially relative descriptors used herein may likewise be interpreted accordingly depending on the particular orientation.

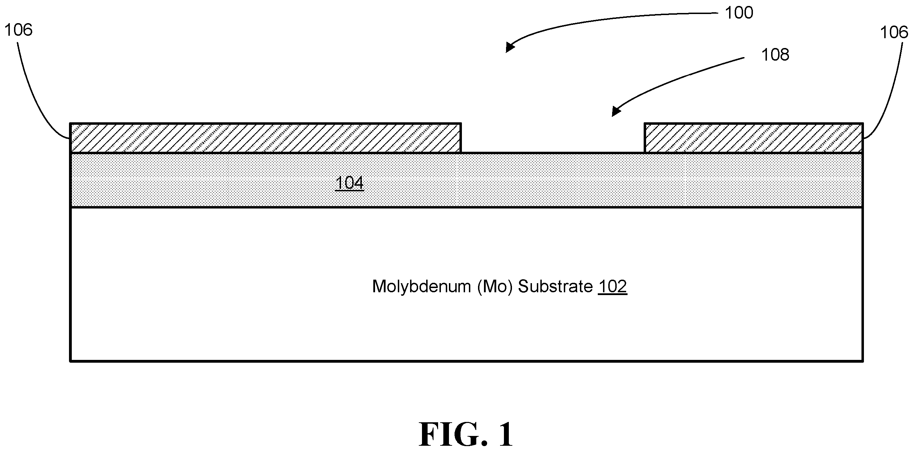

Figure 1 is a cross-sectional view of a cryogenic multilayer interconnect structure 100 including a molybdenum (Mo) substrate 102 that provides a coefficient of thermal expansion (CTE) at room temperature that is a good match with the CTEs of cryogenic electronic chips (not shown) to be attached to the multilayer interconnect structure. In Figure 1, which is not in accordance with present claim 1, the substrate 102 includes only a molybdenum layer. The cryogenic multilayer interconnect structure 100 further includes a first dielectric or insulating layer 104 formed on the Mo substrate 102. The first insulating layer 104 is a polymer dielectric layer in an example, where this polymer dielectric layer may be one of a polyimide (Pl) layer, a polybenzoxazole (PBO) layer, and a benzocyclobuten (BCB) layer. A first superconducting layer 106 is formed on the first insulating layer, where the first superconducting layer is a niobium (Nb) layer in one example. The superconducting layer 106 is then patterned as required, with an opening 108 being formed in the superconducting layer by way of example to illustrate such patterning in the interconnect structure 100.

In the cryogenic multilayer interconnect structure 100, the CTE of the molybdenum substrate 102 at room temperature, which is approximately 5 ppm/K in some example, is a good match with the CTE of cryogenic electronic chips to be attached to the interconnect structure. As will be appreciated by those skilled in the art, a mismatch in the CTE of two different materials attached to one another may result in mechanical stresses being generated between the two materials as the materials experience a temperature change. These mechanical stresses result from forces generated between the two materials due to different rates of expansion as a function of temperature. These forces may include lateral forces in a plane of the two materials as well as forces normal to the planes of the materials and may damage the interconnection of the two materials. For example, a conventional circuit board may be formed from a woven glass and epoxy resin structure known as FR4, which has CTE at room temperature on the order of 14 ppm/K. Where a cryogenic electronic chip is a silicon-based chip, meaning the chip is formed in a silicon substrate, the CTE of this silicon substrate has a CTE on the order of 2.56 ppm/K. As a result, when such a silicon chip is attached to an FR4 based circuit board mechanical stresses between the circuit board and the chip can arise as the structure undergoes a temperature change and these stresses may cause warping, disconnection, or other damage to the structure.

In the interconnect structure 100, the molybdenum substrate 102 has a CTE that provides a good match to the materials in which cryogenic electronic chips to be attached to the structure are typically formed. For example, the molybdenum substrate 102 has a CTE that is a good match with the CTEs of cryogenic electronic chips including substrates of silicon, sapphire, and compound semiconductor substrates. Thus, utilization of the interconnect structure 100 in cryogenic applications improves the reliability of the system by reducing the likelihood of damage to components in the system as these components undergo temperature changes in the range from room temperature (i.e., 20 °C or 293 K) to deep cryogenic temperatures (i.e., less than 10 K). **In** one example, the molybdenum layer forming the substrate 102 is a high purity molybdenum layer having a purity greater than 99.95 %.This high purity of the molybdenum substrate 102 ensures the substrate has a CTE of a desired value and that is a good match with the CTE of cryogenic electronic chips to be attached to the substrate.

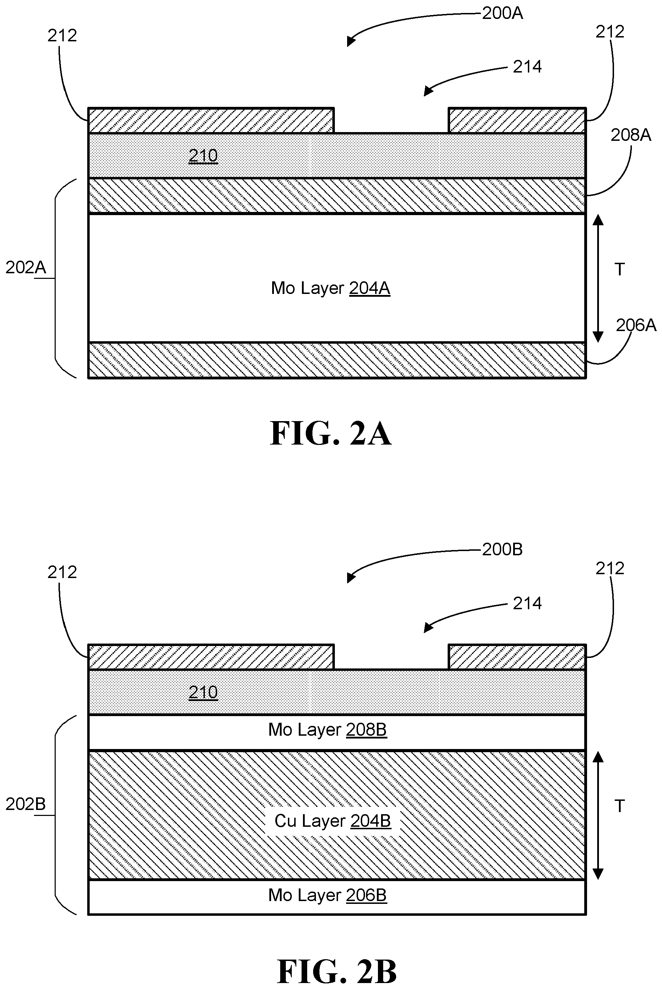

Figure 2A is a cross-sectional view of a cryogenic multilayer interconnect structure 200A including a multilayered molybdenum substrate 202A according to an embodiment of the present invention. In the embodiment of Figure 2A, the multilayered molybdenum substrate 202A includes a molybdenum layer 204A between a first conductive layer 206A and a second conductive layer 208A. The most suitable materials for thermal conduction at deep cryogenic temperatures are pure metals, such as aluminum (Al) and copper (Cu). In accordance with the invention, the multilayered molybdenum substrate 202A is a copper clad molybdenum substrate with each of the first and second conductive layers 206A, 208A being a copper cladding layer. The interconnect structure 200A further includes a first insulating layer 210 formed on the second conductive layer 208A and a first superconducting layer 212 formed on the first insulating layer. The first insulating layer 210 is a polyimide layer and the superconducting layer 212 is a niobium (Nb) layer in one embodiment. The superconducting layer 212 is then patterned, which is again illustrated by way of example through an opening 214 formed in this layer in the interconnect structure 200A. Cryogenic electronic chips and other components may then be attached to the patterned superconducting layer 212.

The multilayered molybdenum substrate 202A has a structure that enables a controlled CTE to be provided, and also has improved thermal conductivity characteristics through inclusion of the copper layers 206A, 208A. The characteristics of the molybdenum layer 204A and the copper layers 206A, 208A may be adjusted to provide the multilayered molybdenum substrate 202A having desired CTE and thermal conductivity characteristics. More specifically, each of the molybdenum layer 204A, first copper layer 206A and second copper layer 208A has a corresponding thickness in the vertical direction, as illustrated through a thickness T shown for the molybdenum layer 204A in Figure 2. The thicknesses of each of these layers 204A-208A may be adjusted to provide the multilayered molybdenum substrate 202A having desired CTE and thermal conductivity characteristics. Specifically, these thicknesses are one parameter that may be controlled to provide the multilayered molybdenum substrate 202A having a CTE that is matched to a CTE of cryogenic electronic chips to be attached to the interconnect structure 200A. Matched does not mean the CTE of the substrate 202A and cryogenic electronic chips are identical but are within a desired range of one another. In addition to the thicknesses, the purity of each of these layers 204A-208A may also be controlled to provide the desired CTE and thermal conductivity characteristics for the substrate 202A, as will be described in more detail below.

As used in the present description, the terms "matched" and "good match" mean the CTEs of the molybdenum substrates 102 and 202A, and other molybdenum substrates described herein, are compatible with electronic components such as cryogenic electronic chips to be attached to the substrates. The CTE of each substrate 102, 202A provides a compatible CTE between the substrate and the cryogenic electronic chips attached to the substrate so that significant mechanical stresses are not generated between the two as the structure experiences a temperature change from room temperature to deep cryogenic temperatures.

In embodiments of the cryogenic multilayer interconnect structure 200A, the multilayered molybdenum substrate 202A is a copper clad molybdenum substrate (i.e., first and second conductive layers 206A, 208A are copper layers) and the characteristics of these layers are controlled to provide a coefficient of thermal expansion at room temperature of 5-8 ppm/K. This is a significantly lower CTE than other common conventional substrates such as an FR4 structure (14 ppm/K), a copper Cu structure (17 ppm/K) and an aluminum Al structure (24 ppm/K). A lower CTE is advantageous, for example, when silicon cryogenic electronic chips (i.e., chips having components formed in silicon) are to be attached, with silicon having a CTE at room temperature in the range of 2.56 ppm/K. The copper clad molybdenum substrate 202A having a CTE at room temperature of 5-8 ppm/K is much closer to the silicon CTE at room temperature in the range of 2.58 ppm/K. In this way the CTE of the copper clad multilayered molybdenum substrate 202A is said to be matched to the CTE of cryogenic electronic chips (i.e., silicon chips in this example) to be attached to the substrate.

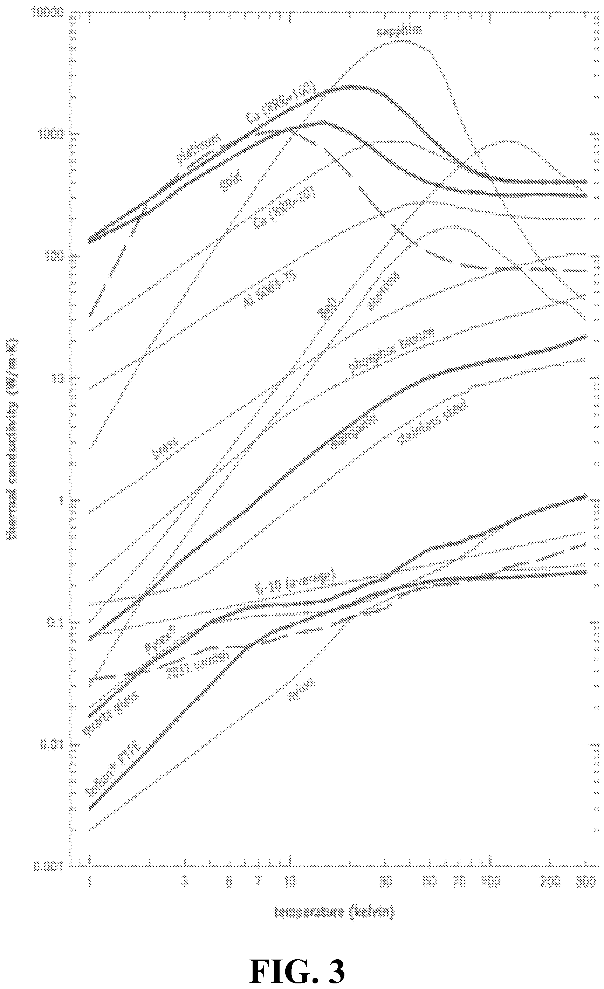

In addition to the controlled CTE characteristics as described above, the multilayered molybdenum substrate 202A also advantageously allows the thermal conductivity of the substrate to be controlled. The purity of both the molybdenum layer 204A and the conductive layers 206A, 208A are necessary to achieve high thermal conductivity values for the substrate 202A at deep cryogenic temperatures. As mentioned above, the most suitable materials for thermal conduction at deep cryogenic temperatures are pure metals, such as aluminum (Al) and copper (Cu). Figure 3 is a graph illustrating the relatively high thermal conductivities of copper (Cu) and aluminum (Al) at deep cryogenic temperatures of less than 10 K. Thus, the inclusion of the conductive layers 206A, 208A as cladding layers surrounding the molybdenum layer 204A may be utilized to significantly increase the thermal conductivity of the substrate 202A in a lateral direction (i.e., orthogonal to the vertical thickness T shown in Figure 2). Through this lateral thermal conductivity, the substrate 202A provides "heat spreading" to dissipate heat of cryogenic electronic components attached to the substrate.

Where the conductive layers 206A, 208A are copper layers the lateral thermal conductivity of the substrate 202A is increased by an order of magnitude or more from approximately 60 W/mK for a pure molybdenum (Mo) substrate to approximately 1000 W/mK at 4.2 K where the substrate 202A is an approximately 20%Cu/60%Mo/20%Cu stack or multilayered structure, where the percentages indicate percentage thicknesses of the respective layers. As mentioned above, varying the thicknesses and the ratio of copper to molybdenum (Cu/Mo) (i.e., the ratio of the thickness of each Cu layer to the thickness of the Mo layer) allows for fine tuning the CTE and thermal conductivity values of the substrate 202A. The selection of the CTE and thermal conductivity values requires a tradeoff in that these parameters are mutually exclusive. Thus, if more copper is added to the substrate 202A (i.e., the thicknesses of the copper layers 206A, 208A are increased) to improve the thermal conductivity of the substrate, the CTE of the substrate will undesirably increase. Conversely, if less copper is added to the substrate 202A (i.e., the thicknesses of the copper layers 206A, 208A are decreased) then the CTE of the substrate will decrease but the thermal conductivity of the substrate will also undesirably decrease. In one embodiment, the multilayer molybdenum substrate 202A is a copper clad structure (layers 206A, 208A are copper) with each of these copper layers having a purity greater than 99.995 % and the molybdenum layer 204A is a high purity molybdenum layer having a purity greater than 99.95 %.

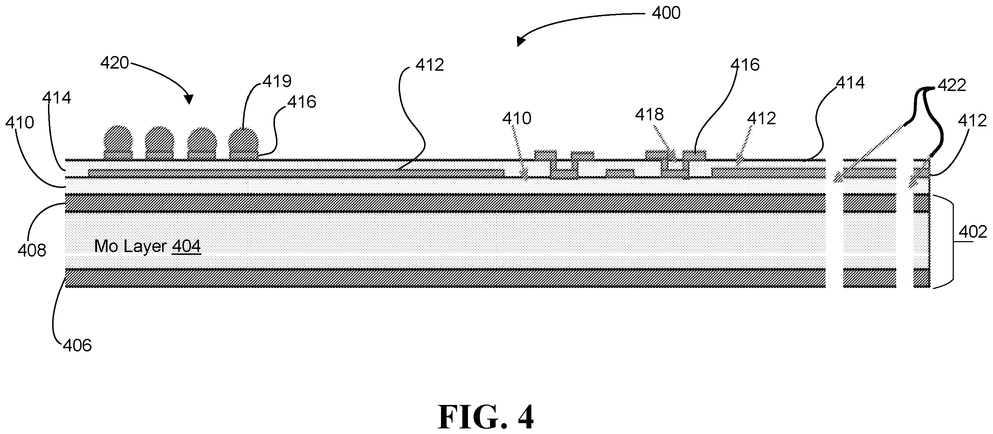

Different superconducting materials may be utilized in further embodiments of cryogenic multilayer interconnect structures according to the present disclosure. For example, in the cryogenic multilayer interconnect structures 100 and 200A of Figures 1 and 2A the superconducting layers 106, 212, as well as superconducting layers in further examples of cryogenic multilayer interconnect structures described below with reference to Figures 4-9, may be formed any suitable superconducting material. For example, these superconducting layers may be formed from niobium (Nb), niobium nitride (NbN), niobium titanium nitride (NbTiN), titanium nitride (TiN), and aluminum (Al), along with combinations of such materials, in embodiments of cryogenic electronic interconnect structures. In addition to a polyimide, different materials may be utilized to form the dielectric or insulating layers 104, 210 in the examples of interconnect structures 100, 200 described above with reference to Figures 1 and 2A, as well as for the insulating layers described below with reference to the embodiments of Figures 4-9. In examples, the insulating layers 104, 210 may be a polymer dielectric layer, where the polymer dielectric layer may be one of a polyimide (Pl) layer, a polybenzoxazole (PBO) layer, and a benzocyclobuten (BCB) layer.

Figure 2B is a cross-sectional view of a cryogenic multilayer interconnect structure 200B including a multilayered molybdenum substrate 202B. In Figure 2B, the multilayered molybdenum substrate 202B includes a copper layer 204B between a first molybdenum layer 206B and a second molybdenum layer 208B. The interconnect structure of 200B further includes a first insulating layer 210 formed and a first superconducting layer 212 formed thereon in the same way as described for these corresponding layers with reference to Figure 2A, and thus these layers are not again discussed in more detail with reference to Figure 2B. The thicknesses of the molybdenum layers 206B, 208B relative to the thickness T of the copper layer 204B may be varied in different implementations to fine tune the CTE and thermal conductivity of the substrate 202B, as discussed in more detail above in relation to the substrate 202A of Figure 2A.

Figure 4 is a cross-sectional view of a cryogenic multilayer interconnect structure 400 illustrating a multilayered molybdenum substrate 402 including a multilayer stack structure including several alternating insulating and superconducting layers according to an embodiment of the present invention. The substrate 402 includes a molybdenum layer 404 sandwiched between a lower conductive layer 406 and upper conductive layer 408. The conductive layers 406 and 408 are copper layers in embodiments of the interconnect structure 400. A first dielectric or insulating layer 410 is formed on an upper surface of the upper conductive layer 408 and a first superconducting layer 412 is formed on this first insulating layer. The first superconducting layer 412 is patterned, such as through etching or other suitable processes, to form portions of this superconducting layer utilized in the formation of the overall interconnect structure 400. A second insulating layer 414 is formed on the patterned first superconducting layer 412 and exposed portions of the first insulating layer 410.

A second superconducting layer 416 is formed on the second insulating layer 414 and patterned as required to form portions of the second superconducting layer utilized in the formation of the overall interconnect structure 400. In the example of Figure 4, the structure of the second superconducting layer also includes vias 418 extending through the second insulating layer 414 to interconnect portions of the second superconducting layer 416 to portions of the first superconducting layer 412. The second superconducting layer 416 includes four bonding pads on the left side of the illustrated structure with conductive bumps 419 formed on these bonding pads to form a bonding pad structure 420. Through holes 422 are formed extending vertically through the structure 400 from the upper surface to a lower surface and may be formed through any suitable means such as by drilling. The multilayered molybdenum substrate 402 corresponds to embodiments of the substrate 202A previously described with reference to Figure 2A in embodiments of the interconnect structure 400, and these embodiments will not again be described in detail. The substrate 402 has a structure to provide a desired CTE and thermal conductivity as determined by the application of the interconnect structure 400 including components (not shown) to be attached to this structure such as a cryogenic electronic chip attached to the conductive bumps 419 of the bonding pad structure 420.

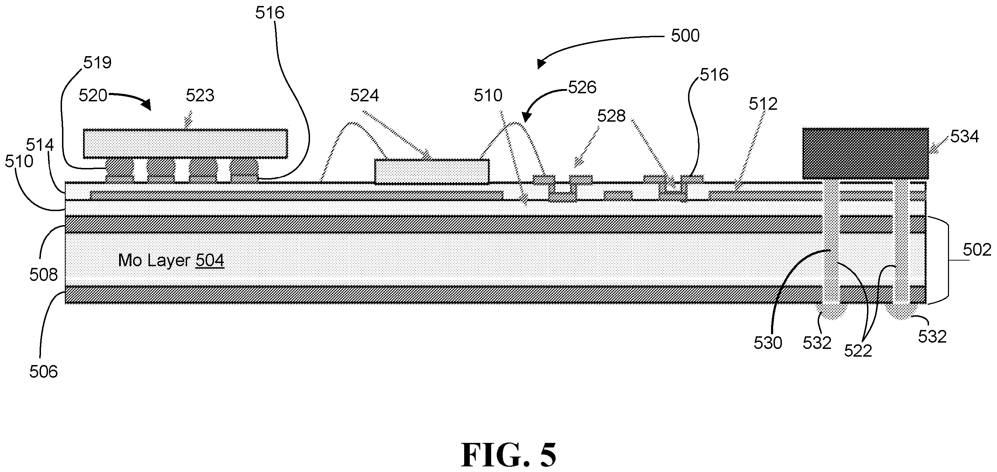

Figure 5 is a cross-sectional view of a cryogenic multilayer interconnect structure 500 including several components attached to the interconnect structure according to a further embodiment. The components 502-520 of the interconnect structure 500 correspond to the components 402-420 of the interconnect structure 400 of Figure 4 and will not again be discussed in detail with reference to Figure 5. In the example embodiment of Figure 5, a first cryogenic electronic chip 523 is coupled to the conductive bumps 519 of the bonding pad structure 520 to both electrically and physically attach the cryogenic electronic chip to the interconnect structure 500. A second cryogenic electronic chip 524 is physically attached to an upper surface of the second insulating layer 514 and is then electrically coupled to the interconnect structure 500 through bonding wires 526, one of which is labeled in Figure 5. Two vias 528 are also illustrated interconnecting bonding pads formed from the second superconducting layer 516 and portions of the first superconducting layer 512. Vias 530 extending in the through holes 522 and interconnect conductive bumps 532 on a lower surface of the substrate 502 and a connector 534 such as a DC or RF connector on an upper surface of the interconnect structure 500.

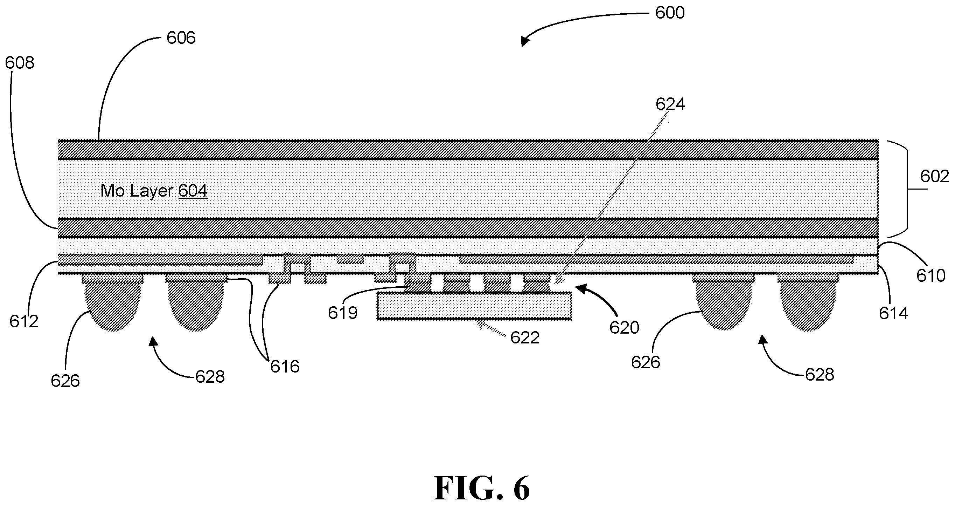

Figure 6 is a cross-sectional view of a cryogenic multilayer interconnect structure 600 including a dual interconnect structure that provides a fanout package according to yet a further embodiment. The components 602-616 correspond to the components 402-420 and 502-520 of Figures 4 and 5 and thus will not again be described in detail. The patterning of the second superconducting layer 616 in the interconnect structure 600 is, however, different than in the embodiments of Figures 4 and 5. A cryogenic electronic chip 622 is physically and electrically coupled through conductive bumps 619 of the bonding pad structure 620 to bonding pads of the second superconducting layer 616. This interconnection corresponds to a first interconnect level 624 of the dual interconnect structure 600. The second superconducting layer 616 is patterned to include bonding pads on the left and right in the structure 600 with conductive bumps 626 being formed on each of these bonding pads to form a second interconnect level 628 of this structure. This dual level 624, 628 interconnect structure provides fanout for connecting external components (not shown) to the cryogenic electronic chip 622 through the interconnect structure 600.

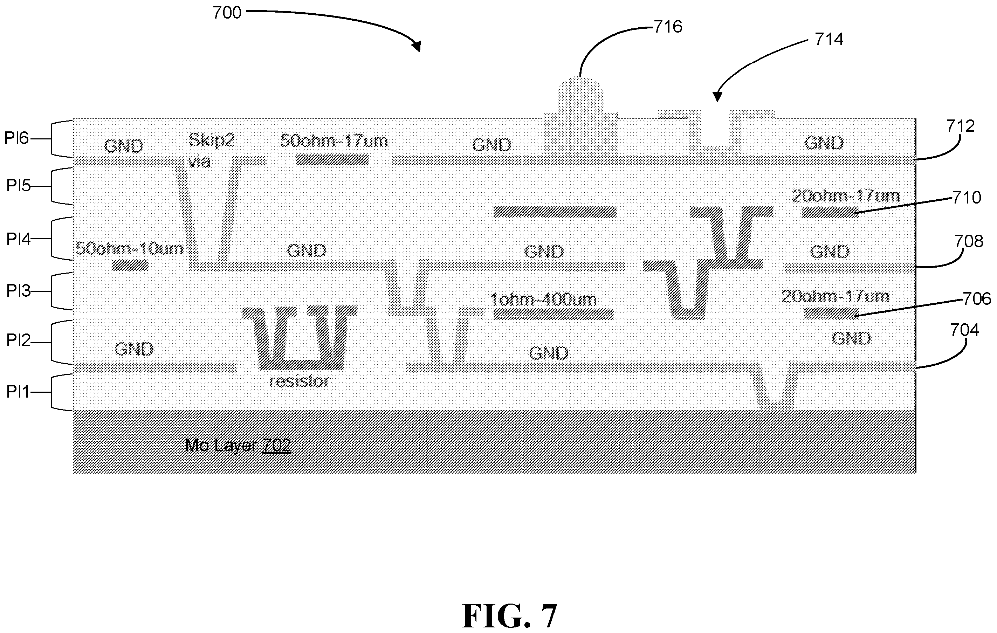

Figure 7 is a cross-sectional view of a cryogenic multilayer interconnect structure 700 including transmission line structures for propagation of radio frequency signals according to a reference example, not in accordance with present claim 1. The interconnect structure 700 includes a substrate formed by a molybdenum layer 702 and includes a plurality of alternating polyimide layers PL1-PL6 and superconducting layers 704-712 form on the molybdenum substrate. The interconnect structure 700 illustrates a variety of different types of components formed in this multiple layer stack structure. The lowest level superconducting layer 704 includes a ground plane portion that is coupled through vias to ground plane portions of the superconducting layers 706, 708 and 712. The lowest level superconducting layer 704 also includes a resistive element that is coupled through vias to the superconducting layer 706.

A first transmission line having an impedance of 1 ohm and a width of 400 micrometers (µm) is formed in superconducting layer 706 along with a second transmission line having an impedance of 20 ohms and a width of 17 µm. The superconducting layer 708 on the left includes a transmission line having an impedance of 50 ohms and a width of 10 µm and is coupled through vias on the right to the superconducting layer 710 which includes on the right a transmission line having an impedance of 20 ohms and a width of 17 µm. A transmission line having an impedance of 50 ohms and a width of 17 µm is formed in the uppermost superconducting layer 712 along with a ground plane portion on the right to which a conductive bump 716 and contact pad 714 extending through polyimide layer PL6 are coupled. In the interconnect structure 700 the molybdenum substrate 702 has a low CTE at room temperature and is thus advantageously utilized in cryogenic applications. The molybdenum substrate 702 will, however, has a moderate thermal conductivity at deep cryogenic temperatures and will accordingly not dissipate as much heat as in embodiments where the substrate includes a high thermal conductivity cladding layers, such as copper cladding layers, as discussed above in relation to Figures 1-6. The transmission lines and resistive element of Figure 7 are examples of components that can be implemented, and other structures may of course be formed.

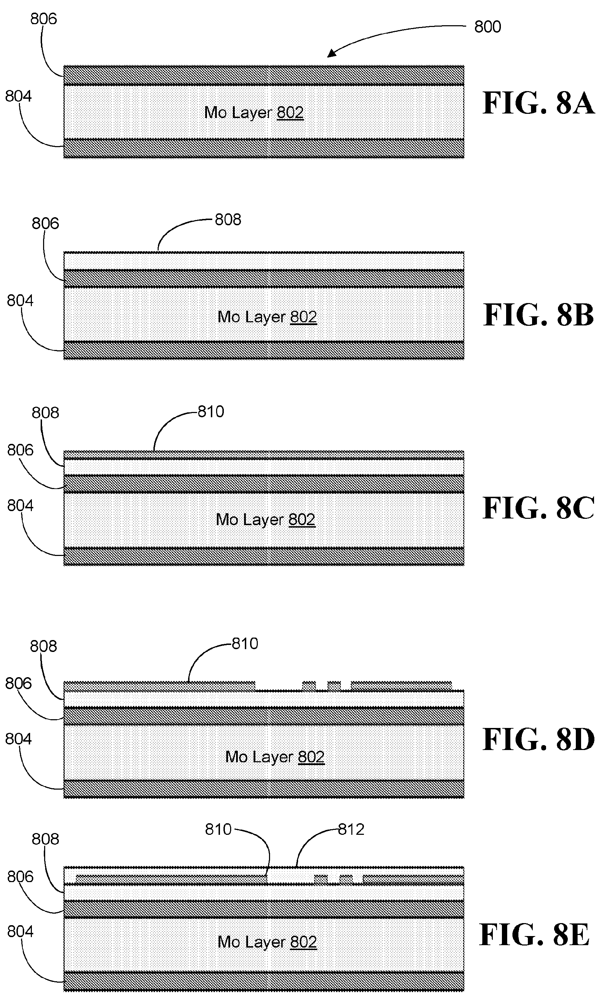

Figures 8A-8I illustrate a process of fabricating a cryogenic multilayer interconnect structure according to an embodiment of the present invention. The process starts in Figure 8A with a molybdenum substrate 800, which includes a molybdenum layer 802 between lower and upper conductive layers 804 and 806. These conductive layers 804, 806 are copper layers. **In** Figure 8B, the method forms on the multilayered molybdenum substrate 800 a first insulating layer 808 on an upper surface of the upper conductive layer 806 of the substrate. The first insulating layer 808 may be formed in different ways. **In** one embodiment, the first insulating layer 808 is formed through deposition of a layer of an insulating material on the upper surface of the upper conductive layer 806.

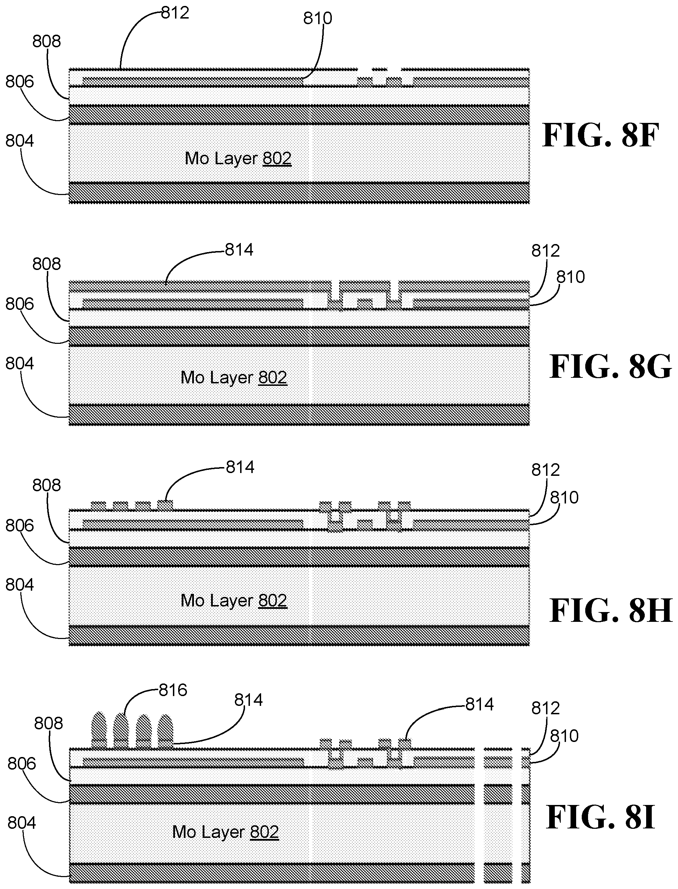

**In** Figure 8C a first superconducting layer 810 is formed on the first insulating layer 808 and is thereafter patterned, such as through etching, as seen in Figure 8D. The first superconducting layer 810 may be formed, for example, through deposition of a superconducting material, such as through sputtering or evaporation, on the upper surface of the first insulating layer 808. After the first superconducting layer 810 is patterned as required, a second insulating layer 812 is formed on the first superconducting layer 810 and on portions of the first insulating layer 808 exposed to during the patterning of the first superconducting layer as seen in Figure 8E. As seen in Figure 8F, portions of the second insulating layer 812 are then removed to form openings in the second insulating layer as part of the formation of superconducting vias to be formed in the structure. Figure 8G shows a second superconducting layer 814 is then formed on the second insulating layer 812 and on portions of the first superconducting layer 810 exposed through the openings in the second insulating layer 812 to thereby form vias interconnecting the first and second superconducting layers 810 and 814. The second superconducting layer 814 is then patterned as required as shown in Figure 8H. This patterning may be done through any suitable method, such as through etching of the second superconducting layer 814, as is also true for the other patterning steps in the method. In the illustrated example, the second superconducting layer 814 is patterned to form contact pads and conductive bumps 816 are thereafter formed on selected ones of these contact pads as illustrated in Figure 8I. These conductive bumps 816 are indium (In) bumps in one embodiment and function to attach a cryogenic electronic chip (not shown) to the interconnect structure of Figure 8I.

In the method of Figures 8A-8I, each of the first insulating layer 808 and the second insulating layer 812 may be formed through deposition of a suitable dielectric material, and in embodiments this dielectric or insulating material is polyimide. Each of the first superconducting layer 810 and the second superconducting layer 814 is formed through deposition of a suitable superconducting material, such as niobium, on the corresponding first and second insulating layers 808, 812 in embodiments of the method. This deposition of superconducting material to form the superconducting layers 810, 814 may be done, for example, through sputtering or evaporation. The patterning of the first and second superconducting layers 810, 814 may be done through etching as mentioned above or through other suitable processes. The formation of the openings in the second insulating layer 812 in Figure 8F may also be done through any suitable process, such as through etching of this insulating layer.

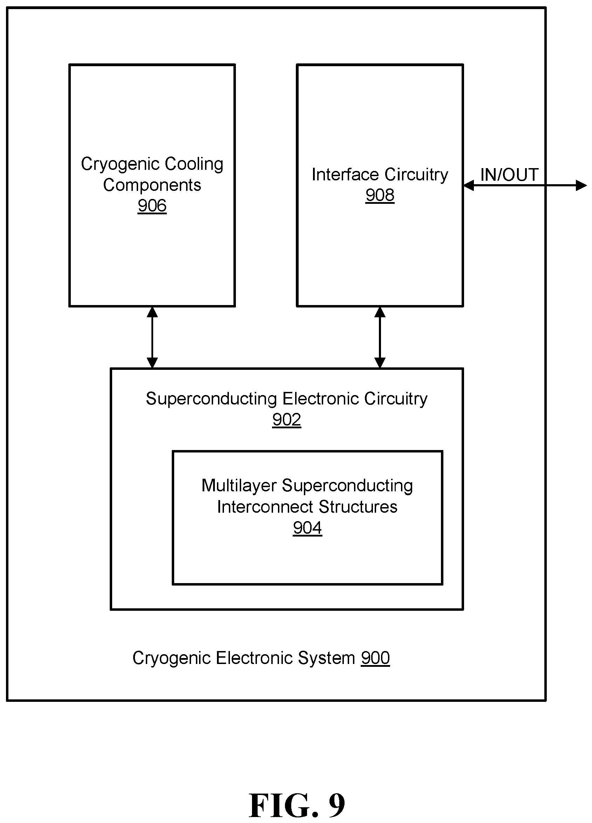

Figure 9 is a simplified functional block diagram of a cryogenic electronic system 900 including superconducting electronic circuitry 902 containing one or more multilayer interconnect structures 904. The superconducting electronic circuitry 902 includes circuitry for performing the required functions of the cryogenic electronic system 900. In one example, the superconducting electronic circuitry 902 corresponds to quantum computing circuitry. The multilayer superconducting interconnect structures 904 correspond to one or more of the interconnect structures described above in relation to Figures 1-8. The cryogenic electronic system 900 includes cryogenic cooling components 906 coupled to the superconducting electronic circuitry 902 to maintain this circuitry at deep cryogenic temperatures during operation. Interface circuitry 908 is also coupled to the superconducting electronic circuitry 902 and functions to provide an interface to receive input data IN from external electronic circuitry (not shown) operating at room temperature and to data from the superconducting electronic circuitry as output data OUT to the external electronic circuitry.

Interconnect structures according to the present disclosure as illustrated in Figures 1-9 allow for providing excellent thermal dissipation, high wiring density, high reliability, low radio frequency (RF) losses, and easy mounting of these structures to cryostats, which are devices utilized to maintain the structures at deep cryogenic temperatures. The use of spin-on dielectrics and sputtered thin films allows these structures to be made in wafer or panel form, which allows for the fabrication of relatively large structures (e.g., up to 61 cm x 61 cm (24"x24")) on equipment designed for panel-level redistribution layer (RDL) packaging or liquid crystal display (LCD) fabrication. Copper RDL packaging on panel-level equipment with ultraviolet (UV) direct write lithography is capable of forming 2/2 µm line/space features. In superconducting electronic circuit this could enable form factors over wide range of sizes from large enough for superconducting backplanes down to smaller fan-out packaging of components.

The various features and processes described above may be used independently of one another or may be combined in various ways. All possible combinations and subcombinations are intended to fall within the scope of this disclosure. The methods and processes described herein are not limited to any particular sequence, and the blocks or states relating thereto can be performed in other sequences that are appropriate. For example, described blocks or states may be performed in an order other than that specifically disclosed, or multiple blocks or states may be combined in a single block or state. The example blocks or states may be performed in serial, in parallel, or in some other manner. Blocks or states may be added to the disclosed example embodiments. The example systems and components described herein may be configured differently than described. For example, elements may be added to the disclosed example embodiments.

Conditional language used herein, such as, among others, "can," "could," "might," "may," and the like, unless specifically stated otherwise, or otherwise understood within the context as used, is generally intended to convey that certain embodiments include, while other embodiments do not include, certain features, elements, and/or steps. Thus, such conditional language is not generally intended to imply that features, elements and/or steps are in any way required for one or more embodiments or are to be performed in any particular embodiment. The terms "comprising," "including," "having," and the like are synonymous and are used inclusively, in an open-ended fashion, and do not exclude additional elements, features, acts, operations, and so forth. Also, the term "or" is used in its inclusive sense (and not in its exclusive sense) so that when used, for example, to connect a list of elements, the term "or" means one, some, or all of the elements in the list.

The above description illustrates various embodiments of the present disclosure along with examples of how aspects of the particular embodiments may be implemented. The above examples should not be deemed to be the only embodiments, and are presented to illustrate the flexibility and advantages of the particular embodiments as defined by the following claims.

## Claims

1. A cryogenic multilayer interconnect structure (200A), comprising:
a substrate (202A) including a molybdenum layer (204A),
a first insulating layer (210) on the substrate (202A); and
a first superconducting layer (212) on the first insulating layer (210),
**characterised in that:**
the substrate (202A) further comprises a first copper layer (206A) and a second copper layer (208A), and the molybdenum layer (204A) is between the first copper layer (206A) and the second copper layer (208A).

2. The cryogenic multilayer interconnect structure (200A) of claim 1, wherein the first insulating layer (210) comprises a polymer dielectric layer.

3. The cryogenic multilayer interconnect structure (200A) of claim 1, wherein the first superconducting layer (212) comprises a material selected from niobium, niobium nitride, niobium titanium nitride, titanium nitride, aluminum, and combinations thereof.

4. The cryogenic multilayer interconnect structure (200A) of claim 1, wherein each of the first copper layer (206A) and the second copper layer (208A) has a purity greater than 99.995 %, and wherein the molybdenum layer (204A) is a high purity molybdenum layer having a purity greater than 99.95 %.

5. The cryogenic multilayer interconnect structure (200A) of claim 1, wherein each of the first copper layer (206A), second copper layer (208A), and molybdenum layer (204A) has a corresponding thickness, and wherein each of these thicknesses are controlled to provide a coefficient of thermal expansion at room temperature of 5 to 8 ppm/K.

6. The cryogenic multilayer interconnect structure of claim 1, wherein the substrate (202A) including the first copper layer (206A), molybdenum layer (204A), and second copper layer (208A) is a 20 % Cu/60 % Mo/20 % Cu stack, wherein the percentages indicate percentage thicknesses of the respective layers.

7. A method of forming a cryogenic multilayer interconnect structure (200A), comprising:
forming a first insulating layer (808) over a first copper layer (806) of a copper clad molybdenum substrate including a molybdenum layer (802) between the first copper layer (806) and a second copper layer (804);
forming a first superconducting layer (810) over the first insulating layer (808); patterning the first superconducting layer (810);
forming a second insulating layer (812) over the first superconducting layer (810);
forming openings in the second insulating layer (812) to expose portions of the first superconducting layer (810);
forming a second superconducting layer (814) over the second insulating layer (812) and in the openings to form vias in the openings that interconnect the first and second superconducting layers (810, 814); and
patterning the second superconducting layer (814).

8. The method of claim 7, wherein forming the first insulating layer (808) and forming the second insulating layer (812) comprise spin coating one or more insulating material on the first copper layer (806) and the first superconducting layer (810), respectively.

9. The method of claim 8, wherein the one or more insulating material is one of a polyimide material, a polybenzoxazole material, and a benzocyclobuten material.

10. The method of claim 7, wherein forming the first superconducting layer (810) and the second superconducting layer (814) comprise depositing a superconducting material on the first insulating layer (808) and the second insulating layer (812), respectively.

11. The method of claim 10, wherein depositing the superconductor material comprises sputtering or evaporation of the superconducting material.

12. The method of claim 10, wherein the superconductor material comprises one of niobium and a superconducting material including titanium.

## Patentansprüche

1. Kryogene Mehrschichtverbindungsstruktur (200A), umfassend:
ein Substrat (202A), das eine Molybdänschicht (204A) einschließt,
eine erste isolierende Schicht (210) auf dem Substrat (202A); und
eine erste supraleitende Schicht (212) auf der ersten isolierenden Schicht (210),
**dadurch gekennzeichnet, dass:**
das Substrat (202A) ferner eine erste Kupferschicht (206A) und eine zweite Kupferschicht (208A) umfasst, und die Molybdänschicht (204A) zwischen der ersten Kupferschicht (206A) und der zweiten Kupferschicht (208A) liegt.

2. Kryogene Mehrschichtverbindungsstruktur (200A) nach Anspruch 1, wobei die erste isolierende Schicht (210) eine dielektrische Polymerschicht umfasst.

3. Kryogene Mehrschichtverbindungsstruktur (200A) nach Anspruch 1, wobei die erste supraleitende Schicht (212) ein Material umfasst, das ausgewählt ist aus Niob, Niobnitrid, Niobtitannitrid, Titannitrid, Aluminium und Kombinationen davon.

4. Kryogene Mehrschichtverbindungsstruktur (200A) nach Anspruch 1, wobei jede der ersten Kupferschichten (206A) und der zweiten Kupferschichten (208A) eine Reinheit von mehr als 99,995 % aufweist, und wobei die Molybdänschicht (204A) eine hochreine Molybdänschicht mit einer Reinheit von mehr als 99,95 % ist.

5. Kryogene Mehrschichtverbindungsstruktur (200A) nach Anspruch 1, wobei jede der ersten Kupferschichten (206A), der zweiten Kupferschicht (208A) und der Molybdänschicht (204A) eine entsprechende Dicke aufweist und wobei jede dieser Dicken so gesteuert wird, dass sie einen Wärmeausdehnungskoeffizienten bei Raumtemperatur von 5 bis 8 ppm/K aufweist.

6. Kryogene Mehrschichtverbindungsstruktur nach Anspruch 1, wobei das Substrat (202A), das die erste Kupferschicht (206A), die Molybdänschicht (204A) und die zweite Kupferschicht (208A) einschließt, ein 20 % Cu/60 % Mo/20 % Cu-Stapel ist, wobei die Prozentangaben die prozentualen Dicken der jeweiligen Schichten angeben.

7. Verfahren zur Bildung einer kryogenen Mehrschichtverbindungsstruktur (200A), umfassend:
Bilden einer ersten isolierenden Schicht (808) über einer ersten Kupferschicht (806) eines kupferbeschichteten Molybdänsubstrats mit einer Molybdänschicht (802) zwischen der ersten Kupferschicht (806) und einer zweiten Kupferschicht (804);
Bilden einer ersten supraleitenden Schicht (810) über der ersten isolierenden Schicht (808);
Strukturieren der ersten supraleitenden Schicht (810);
Bilden einer zweiten isolierenden Schicht (812) über der ersten supraleitenden Schicht (810);
Bilden von Öffnungen in der zweiten isolierenden Schicht (812), um Abschnitte der ersten supraleitenden Schicht (810) freizulegen;
Bilden einer zweiten supraleitenden Schicht (814) über der zweiten isolierenden Schicht (812) und in den Öffnungen, um Durchgänge in den Öffnungen zu bilden, die die erste und zweite supraleitende Schicht (810, 814) miteinander verbinden; und
Strukturieren der zweiten supraleitenden Schicht (814).

8. Verfahren nach Anspruch 7, wobei das Bilden der ersten isolierenden Schicht (808) und das Bilden der zweiten isolierenden Schicht (812) die Schleuderbeschichtung eines oder mehrerer isolierender Materialien auf der ersten Kupferschicht (806) bzw. der ersten supraleitenden Schicht (810) umfasst.

9. Verfahren nach Anspruch 8, wobei das eine oder die mehreren isolierenden Materialien ein Polyimidmaterial, ein Polybenzoxazolmaterial oder ein Benzocyclobutenmaterial sind.

10. Verfahren nach Anspruch 7, wobei das Bilden der ersten supraleitenden Schicht (810) und der zweiten supraleitenden Schicht (814) das Abscheiden eines supraleitenden Materials auf der ersten isolierenden Schicht (808) bzw. der zweiten isolierenden Schicht (812) umfasst.

11. Verfahren nach Anspruch 10, wobei das Abscheiden des supraleitenden Materials das Sputtern oder Verdampfen des supraleitenden Materials umfasst.

12. Verfahren nach Anspruch 10, wobei das supraleitende Material entweder Niob oder ein supraleitendes Material einschließlich Titan umfasst.

## Revendications

1. Structure d'interconnexion multicouche cryogénique (200A), comprenant :
un substrat (202A) comportant une couche de molybdène (204A),
une première couche isolante (210) sur le substrat (202A) ; et
une première couche supraconductrice (212) sur la première couche isolante (210),
**caractérisée en ce que** :
le substrat (202A) comprend en outre une première couche de cuivre (206A) et une seconde couche de cuivre (208A), et la couche de molybdène (204A) se trouve entre la première couche de cuivre (206A) et la seconde couche de cuivre (208A).

2. Structure d'interconnexion multicouche cryogénique (200A) selon la revendication 1, dans laquelle la première couche isolante (210) comprend une couche diélectrique polymère.

3. Structure d'interconnexion multicouche cryogénique (200A) selon la revendication 1, dans laquelle la première couche supraconductrice (212) comprend un matériau choisi parmi le niobium, le nitrure de niobium, le nitrure de titane et de niobium, le nitrure de titane, l'aluminium et des combinaisons de ceux-ci.

4. Structure d'interconnexion multicouche cryogénique (200A) selon la revendication 1, dans laquelle chacune de la première couche de cuivre (206A) et de la seconde couche de cuivre (208A) a une pureté supérieure à 99,995 %, et dans laquelle la couche de molybdène (204A) est une couche de molybdène de haute pureté ayant une pureté supérieure à 99,95 %.

5. Structure d'interconnexion multicouche cryogénique (200A) selon la revendication 1, dans laquelle chacune de la première couche de cuivre (206A), de la seconde couche de cuivre (208A) et de la couche de molybdène (204A) a une épaisseur correspondante, et dans laquelle chacune de ces épaisseurs est contrôlée pour fournir un coefficient de dilatation thermique à température ambiante de 5 à 8 ppm/K.

6. Structure d'interconnexion multicouche cryogénique selon la revendication 1, dans laquelle le substrat (202A) comportant la première couche de cuivre (206A), la couche de molybdène (204A) et la seconde couche de cuivre (208A) est un empilement de 20 % de Cu/60 % de Mo/20 % de Cu, dans laquelle les pourcentages indiquent les épaisseurs en pourcentage des couches respectives.

7. Procédé de formation d'une structure d'interconnexion multicouche cryogénique (200A), comprenant :
la formation d'une première couche isolante (808) sur une première couche de cuivre (806) d'un substrat en molybdène recouvert de cuivre comportant une couche de molybdène (802) entre la première couche de cuivre (806) et une seconde couche de cuivre (804) ;
la formation d'une première couche supraconductrice (810) sur la première couche isolante (808) ;
le modelage de la première couche supraconductrice (810) ;
la formation d'une seconde couche isolante (812) sur la première couche supraconductrice (810) ;
la formation d'ouvertures dans la seconde couche isolante (812) pour exposer des parties de la première couche supraconductrice (810) ;
la formation d'une seconde couche supraconductrice (814) sur la seconde couche isolante (812) et dans les ouvertures pour former des vias dans les ouvertures qui interconnectent les première et seconde couches supraconductrices (810, 814) ; et
le modelage de la seconde couche supraconductrice (814).

8. Procédé selon la revendication 7, dans lequel la formation de la première couche isolante (808) et la formation de la seconde couche isolante (812) comprennent le dépôt par centrifugation d'un ou plusieurs matériaux isolants sur la première couche de cuivre (806) et la première couche supraconductrice (810), respectivement.

9. Procédé selon la revendication 8, dans lequel le ou les matériaux isolants sont l'un d'un matériau polyimide, d'un matériau polybenzoxazole et d'un matériau benzocyclobutène.

10. Procédé selon la revendication 7, dans lequel la formation de la première couche supraconductrice (810) et de la seconde couche supraconductrice (814) comprend le dépôt d'un matériau supraconducteur sur la première couche isolante (808) et la seconde couche isolante (812), respectivement.

11. Procédé selon la revendication 10, dans lequel le dépôt du matériau supraconducteur comprend la pulvérisation cathodique ou l'évaporation du matériau supraconducteur.

12. Procédé selon la revendication 10, dans lequel le matériau supraconducteur comprend l'un du niobium et d'un matériau supraconducteur comportant du titane.
